# EUROPÄISCHE PATENTSCHRIFT

(11) **EP 1 576 641 B1**
(45) Veröffentlichungstag und Bekanntmachung des Hinweises auf die Patenterteilung: **05.09.2007**
(21) Anmeldenummer: 03753214.0
(22) Anmeldetag: 30.10.2003
(51) Int. Cl.: H01J 37/32, C23C 14/32

(54) **VACUUMARCQUELLE MIT MAGNETFELDERZEUGUNGSEINRICHTUNG**
VACUUM ARC SOURCE COMPRISING A DEVICE FOR GENERATING A MAGNETIC FIELD
SOURCE D'ARC SOUS VIDE COMPRENANT UN DISPOSITIF DE PRODUCTION DE CHAMP MAGNETIQUE

(30) Priorität: 19.12.2002 CH 216302
(43) Veröffentlichungstag der Anmeldung: 21.09.2005
(73) Patentinhaber: OC Oerlikon Balzers AG, 9496 Balzers (LI)
(72) Erfinder: SCHÜTZE, Andreas, Marina del Rey, CA 90292 (US); WOHLRAB, Christian, A-6800 Feldkirch (AT)
(86) Internationale Anmeldenummer: PCT/CH2003/000710
(87) Internationale Veröffentlichungsnummer: WO 2004/057642

(56) Entgegenhaltungen:
- WO-A-02/077318
- US-A- 5 298 136

## Beschreibung

Die vorliegende Erfindung betrifft eine Vakuumarcquelle zum Betreiben einer Lichtbogenentladung gemäss Anspruch 1, eine mit einer solchen Arcquelle ausgestattete Anlage gemäss Anspruch 17 , sowie ein Verfahren zum Betreiben einer Lichtbogenentladung gemäss Anspruch 21.

Arcquellen wie sie in einer Vakuumkammer zum Verdampfen unterschiedlicher Materialien und/oder als Ionenquelle bekannt sind, werden zur Beschichtung und Vorbehandlung unterschiedlicher Werkstücke verwendet. Aufgrund der hohen punktförmig eingebrachten Energie des auf der Targetoberfläche der Arcquelle laufenden, im folgenden Funken genannten, Lichtbogens, kommt es neben der Emission von gasförmigen, grossteils ionisierten Teilchen, insbesondere bei einem "Festbrennen" des Funkens mit der Folge einer explosionsartigen Verdampfung, auch zur Emission von Makropartikel, deren Durchmesser bis zu einigen Mikrometern und mehr erreichen kann. Nach der Beschichtung wird somit die Oberflächenrauhigkeit vorher beispielsweise polierter Werkstücke im wesentlichen durch die Anzahl und Größe der auf der Schichtoberfläche haftenden bzw. in die Schicht eingewachsenen Makropartikel bestimmt . Daher sind die so abgeschiedenen Schichten relativ rauh, was sich nachteilig bei der Anwendung eines beschichteten Werkzeugs oder Bauteils auswirkt. Weiters verlässt ein Grossteil der Makropartikel in einem relativ flachen Winkel die Oberfläche des Targets, wodurch bei Beschichtungsprozessen wertvolles Material verloren geht, das sich auf den Innenflächen der Vakuumkammer abscheidet.

Um glattere Schichten abzuscheiden wurden unterschiedliche Lösungen vorgeschlagen. So wurden beispielsweise Arcquellen ausserhalb der optischen Sichtlinie der Werkstücke angebracht und die ionisierten Teilchen mittels Magnetfeldern in Richtung der Werkstücke gelenkt, wodurch bei einem hohen technischen Aufwand zwar glattere Schichten erzielt, gleichzeitig aber die Beschichtungsrate wesentlich herabgesetzt wurde.

Weiters wurden unterschiedliche Arcquellen entwickelt, um den Funken möglichst rasch auf einer definierten Bahn über die Targetoberfläche zu bewegen und so einen zu hohen Energieeintrag auf eine kleine Fläche oder gar ein "Festbrennen" zu vermeiden. Dabei wurde der Funken beispielsweise durch einen oder mehrere hinter dem Target bewegte Magnete auf eine geschlossene Kreisbahn gezwungen.

Eine andere Möglichkeit den Funken zu steuern wird in US 5,298,136 beschrieben. Dieses Dokument wird als nächster Stand der Technik angesehen. Eine dort offenbarte Arcquelle zeigt ein kreisförmiges Target, das von einem becherförmigen Polschuh mit einem zentralen, bis an die Targetrückseite geführten Polstück und einer dazwischen angeordneten Spule, seitlich von hinten umfasst wird. Dadurch wird über dem Target ein Magnetfeld erzeugt, dessen senkrechte Komponente in Targetmitte ein positives Maximum aufweist, symmetrisch zu kleineren Werten bis zu einem negativen Minimum im Randbereich abfällt um anschliessend wieder asymptotisch in Richtung der Abszisse anzusteigen. Ähnliche Magnetfelder können auch in bekannter Weise durch Anordnung von Permanentmagneten an der Rückseite des Targets erzeugt werden. Dabei definiert der Durchgang der Feldlinien durch die Abszisse (d.h. Nulldurchgang der einem Wechsel der Feldrichtung entspricht) auf der Targetoberfläche eine in sich geschlossene (kreisförmige) Linie, auf der die senkrechte Komponente des Magnetfelds Null ist. Auf dieser Nullinie erfährt der, bei einem beispielsweise kathodisch geschaltetem Target, entsprechend der technischen Stromrichtung aus dem Plasma ins Target eintretende Funken keine radiale, wohl aber eine hohe tangentiale Beschleunigung, da auf derselben Linie die parallele Komponente des Magnetfelds ein Maximum aufweist. Die solcherart erzielte hohe Umlaufgeschwindigkeit des Funkens verhindert ein "Festfressen" wirkungsvoll, bewirkt aber gleichzeitig eine schlechte Targetausnutzung, da im wesentlichen nur ein schmaler Kreisring des Targets abgetragen wird.
Um dies zu verbessern wurde zusätzlich eine, das Target und den Polschuh im oberen Bereich umfassende Solenoidspule vorgesehen, mit der der Radius der durch Polschuh und darin angeordneter Spule erzeugten Nullinie radial verschoben werden kann.
Der dazu erforderliche technische Aufwand ist jedoch verhältnismässig gross, da für beide Spulen jeweils eine unabhängige Strom/Spannungs-Kontrolleinheit vorzusehen ist, wobei zumindest eine davon zur Abgabe zeitlich veränderbarer Strom/Spannungssignale geeignet sein muss, um eine periodische Expansion/Kontraktion der Nullinie auf dem Target zu ermöglichen. Allerdings wird trotz des hohen Aufwands auch bei einer solcherart ausgeführten Arcquelle ein relativ grosser Bereich in der Targetmitte nur wenig oder gar nicht abgetragen.

Die Aufgabe der vorliegenden Erfindung liegt darin die erwähnten Nachteile des Standes der Technik zu beseitigen.

Insbesondere besteht die Aufgabe darin, eine Vakuumarcquelle und ein Verfahren zum Betreiben einer Lichtbogenentladung zu realisieren, die, bzw. das im Vergleich zu herkömmlich verwendeten Quellen, bzw. im Vergleich zu herkömmlichen Verfahren, insgesamt verbesserte, wirtschaftlichere Behandlungsprozesse mit hoher Schichtqualität erlaubt. Im einzelnen betrifft dies besonders folgende Punkte:
- Verbesserung der Targetausnutzung,
- Verlängerung der Targetstandzeit,
- Erhöhung der pro Target erzielbaren Beschichtungsprozesse,
- Reduzierung der Prozesszeiten,
- Reduzierung der Oberflächenrauhigkeit der abgeschiedenen Schichten.

Zur Lösung der Aufgabe wird erfindungsgemäss eine Vakuumarcquelle gemäss Anspruch 1, eine Vakuumanlage gemäss Anspruch 17, sowie ein Vorgehen nach dem Verfahren in Anspruch 21 vorgeschlagen.

Überraschenderweise hat sich gezeigt, dass bei Einstellung eines Magnetfelds an der Oberfläche eines Targets, dessen senkrechte Komponente B_{┴} über einen Grossteil der Oberfläche im wesentlichen konstant nahe oder bei Null verläuft, ein Funkenverlauf ermöglicht wird, bei der der Funken schnell und gleichmässig über die gesamte oder zumindest einen grossen Teil der Targetoberfläche läuft. Dadurch bleibt einerseits der vom einzelnen Funken pro Zeiteinheit an der Targetoberfläche aufgeschmolzen Bereich klein und die Grösse und Anzahl der aus dem Schmelzbad emittierten Makroteilchen veringert sich. Andererseits kann damit eine bessere Ausbeute erzielt werden, als mit einem über einen verhältnismässig kleinen Bereich des Targets zwangsgeführten Funken.
Vorteilhafterweise wird dabei die Magnetfeldkomponente B_{⊥} kleiner 30, bevorzugt kleiner 20, insbesondere bevorzugt kleiner 10 Gauss gewählt. Im Randbereich der Targetoberfläche können die Werte B_{⊥R} der senkrechte Magnetfeldkomponente gegenüber den Werten B_{⊥} im Mittenbereich der Targetoberfläche ansteigend, fallend und/oder das Vorzeichen wechselnd eingestellt werden.
Der Grossteil der Oberfläche, d.h. der Bereich in dem die senkrechte Komponente B_{┴} im wesentlichen konstant nahe oder bei Null verläuft, erstreckt sich dabei vorteilhafterweise von einem Mittenbereich der Targetoberfläche bis zu einem Randbereich und umfasst zumindest 50%, bevorzugt aber zumindest 60% des oder der geometrisch bestimmenden Maße. Im Falle eines beispielsweise rechteckigen Targets also zumindest 50 bzw. 60% der Seiten a, b, im Falle eines kreisförmigen Targets also zumindest 50 bzw. 60% des Radius. Im Randbereich der Targetoberfläche können die Werte B_{┴R} der senkrechte Magnetfeldkomponente gegenüber den Werten B_{⊥} im Mittenbereich der Targetoberfläche ansteigend, fallend und/oder das Vorzeichen wechselnd eingestellt werden.

Der Wert der parallelen Magnetfelkomponente B ₗₗ kann dabei in der Mitte im wesentlichen ebenfalls auf Null, in Richtung des Randes der Targetoberfläche aber ansteigend, bevorzugt symmetrisch gegenüber der Targetmitte ansteigend, eingestellt werden. Wird beispielsweise bei kreisförmigen Targets vom Rand bis in die Nähe des Mittenbereichs ein Magnetfeld mit einer annähernd linear steigend Komponente Bₗₗ angelegt, so steigt die auf den Funken tangential im oder gegen den Uhrzeigersinn wirkende Kraft gegen den Rand des Targets an, wodurch der Funken über den Radius mit annähernd konstanter Winkelgeschwindigkeit laufen kann.

Ein solches Magnetfeld kann mit einer Vakuumarcquelle mit einer **Magnetfelderzeugungsvorrichtung** hergestellt werden, die zumindest zwei entgegengesetzt gepolte Magnetsysteme umfasst.

Die folgenden Ausführungen beschreiben beispielhaft verschiedene Vakuumarcquellen mit denen ein solches Magnetfeld über der Targetoberfläche hergestellt werden kann.

Als **Erstes** der zumindest zwei entgegengesetzt gepolten **Magnetsystem**e kann beispielsweise eine hinter dem Target angebrachte erste elektromagnetische Spule vorgesehen werden, die in sich wiederum aus mehreren Spulen aufgebaut sein kann. Vorteilhafterweise decken sich dabei die Innenabmessungen der ersten Spule im wesentlichen mit einer Abweichung von höchstens plus/minus 30%, bevorzugt plus/minus 20% mit der Projektion der Aussenabmessungen der Oberfläche des Targets. Dadurch wird bei Anlegen einer Spannung von der dann stromdurchflossenen Spule ein homogenes, im wesentlichen senkrecht zur Oberfläche des Targets verlaufendes Magnetfeld erzeugt. Die auf dem Grossteil der Oberfläche im Verhältnis zur senkrechten Komponente kleine parallele Komponente des Magnetfeld ist im Mittenbereich der Oberfläche Null und steigt gegen den Rand hin an. Die Verwendung einer noch grösseren ersten Spule ist zwar möglich aber wenig praktisch, bei Verwendung kleinerer Durchmesser wird der parallele Anteil zu gross, oder es kommt sogar zu einem hier unerwünschten Wechsel der Feldrichtung.
Solche Felder können mit Solenoid- also quellenfreien Spulen, ohne zusätzlichen Polschuh bzw. magnetischem Kern erzeugt werden. Je nach Abstand zur Targetoberfläche, bzw. Durchmesser der Spule, vergrössert oder verkleinert sich dabei der Anteil der parallelen Komponente des Magnetfelds.

Eine andere Möglichkeit zur Ausführung des ersten Magnetsystems kann aus einem oder mehreren hinter dem Target, bzw. hinter einer an der Rückseite des Targets befestigten Kühlplatte, angebrachten Permanentmagneten bestehen. Die damit an der Targetoberfläche erzeugten magnetischen Felder sollten in etwa einem Feld einer wie oben ausgeführte Solenoidspule entsprechen, also relativ klein sein. Daher sollten die Permanentmagnete entweder selbst eine geringe Feldstärke aufweisen oder entsprechend vom Target beabstandet angeordnet werden. Weiters ist zu beachten, dass hier ebenso wie bei Verwendung einer wie oben beschriebenen Spule, nicht bereits durch das erste Magnetsystem eine Umkehr der Feldrichtung an der Targetoberfläche bewirkt wird. Eine wie aus dem Stand der Technik bekannte Anordnung mit beispielsweise alternierenden Polungen zwischen Mitten- und Randbereich ist also zu vermeiden. Eine einfache Möglichkeit bietet hier beispielsweise die Verwendung von dünnen sogenannten Plastoferrit-Magneten, die je nach einzustellender Feldstärke in Form ein- oder mehrlagiger Scheiben oder Mehrecke, möglichst gleichförmig auf der Rückseite des Targets, analog zu oben bis in einem Bereich von plus/minus 30%, bevorzugt plus/minus 20% der Aussenabmessungen der Oberfläche des Targets angebracht werden können.

Als Zweites Magnetsystem wird vorteilhafterweise zumindest eine das erste Magnetsystem umfassende bzw. dazu koaxial angeordnete Spule vorgesehen. Diese kann beispielsweise das erste Magnetsystem bzw. Target seitlich umfassend oder bevorzugt hinter dem ersten Magnetsystem bzw. Target angeordnet sein.
Auch für eine hinter dem ersten Magnetsystem angeordnete zweite Spule ist es vorteilhaft einen grösseren Durchmesser als den des ersten Magnetsystems bzw. der ersten Spule vorzusehen. Ebenso hat sich eine grössere Windungszahl als günstig erwiesen, da es damit leichter ist, das senkrechte Magnetfeld in Verbindung mit der Wirkung des ersten Magnetsystems an der Oberfläche im wesentlichen auf Null einzustellen. Bei gleicher Windungszahl müsste diese Wirkung durch einen wesentlich höheren Stromfluss eingestellt werden, wodurch es zu einer thermischen Überbelastung der zweiten Spule kommen kann. Zusätzlich kann mit einer solchen zweiten in diesesm Fall stärkeren Spule auch ein entgegen der Wirkung des ersten Magnetsystems gerichtetes zweites Magnetsystem ein in die Vakuumkammer hineinwirkendes Magnetfeld erzeugen, das ein Bündeln des sonst diffusen Arcplasmas zu einem auch Plasmajet genannten Plasmastrahl erlaubt. Dabei heben sich die entgegengesetzten parallelen Komponenten der zwei Magnetsystem je nach Abstand vom Target teilweise oder vollständig auf, was die Bündelung bewirkt, während das stärkere senkrechte Feld des zweiten Magnetsystems nur im unmittelbaren Oberflächenbereich des Targets vom schwächeren ersten Magnetsystem aufgehoben wird. Dies ist vorteilhaft, da damit ein auf die zu behandelnden Werkstücke gerichteter Teilchenstrom erzeugt werden kann, was beispielsweise höhere Ätzraten oder ein rascheres Schichtwachstum und durch die damit erzielbaren Verkürzungen der Prozesszeiten eine insgesamt längere Standzeit der Targets ermöglicht.
Die Anordnung des ersten als auch des zweiten Magnetsystems hinter dem Target bietet weiters den Vorteil, dass beide Magnetsysteme von aussen zugänglich montiert werden können und nicht den hohen Temperaturen und einer eventuellen Beschichtung in der Behandlungskammer ausgesetzt sind.

Ein vergleichbarer Effekt kann auch mit einer in einem Abstand vor dem Target angeordneten Spule erreicht werden. Wird als erstes Magnetsystem ebenfalls eine Spule verwendet, kann die zweite Spule nun ähnlich oder sogar gleich aufgebaut sein. Bei einer solchen mehr oder weniger gegenüber der Targetebene symmetrischen Anordnung der Spulen muss auch zur Erzeugung eines Plasmajets das Magnetfeld der zweiten nicht zwingend grösser als das der ersten Spule sein, womit beide Spulen bei ähnlicher Geometrie auch mit einer gemeinsamen Strom/Spannungsquelle betrieben werden können. Die Feineinstellung des Magnetfelds kann dabei in einfacher Weise durch regelbare Widerstände oder verstellbarer Beabstandung zumindest einer Spule erfolgen. Da in diesem Fall das zweite Magnetsystem dem Teilchenstrom der Arcquelle ausgesetzt ist, sind jedoch zusätzliche Schutzvorkehrungen wie eine Kühlung bzw. abnehmbare Schutzverkleidung oder andere bekannte Massnahmen vorzusehen um einen dauerhaften Betrieb zu gewährleisten.

Wird sowohl für das erste, als auch für das zweite Magnetsystem jeweils zumindest eine Spule verwendet, so ist, wie aus oben dargelegten Ausführungen leicht zu folgern, die jeweils angelegte Spannungsquelle bzw. Spannungsquellen so anzulegen, dass die Spulenströme jeweils in entgegengesetzte Richtungen, d.h. im wesentlichen im bzw. gegen den Uhrzeigersinn, fliessen.

Die oben beschriebenen Magnetfelderzeugungsvorrichtungen eignen sich sowohl zum Einsatz mit kathodisch als auch mit anodisch betriebenen, insbesondere ebenen Arcquellen und können bei Verwendung zumindest einer Spule einfach, beispielsweise durch Änderung des Spulenstroms, aber auch durch Änderung des Abstands zumindest eines Magnetsystems von der Targetoberfläche, auf unterschiedliche Targetmaterialen und/oder Targetdicken eingestellt werden. Die Targetgeometrie kann dem jeweiligen Bedarf angpasst und entsprechende Magnetfelderzeugungsvorrichtungen beispielsweise sowohl für runde als auch vier- oder mehreckige Quellen erfindungsgemäss ausgeführt werden.
Ein Ändern des oder der Spulenströme während eines Ätz- bzw. Beschichtungsprozesses ist somit nicht notwendig, wenn auch prinzipiell möglich. Der, bzw. die Funken laufen weiterhin in einem, ähnlich wie von sogenannten "random Arc"-Quellen bekannten, Zufallsmustern über die Targetoberfläche, werden aber durch die Magnetfelder der erfindungsgemäss ausgeführten Arcquelle so geführt bzw. beschleunigt, dass die Funken feiner verteilt und die Spritzerhäufigkeit wesentlich reduziert werden. Erstaunlicherweise konnte dabei auch im Mittenbereich des Targets, wo sowohl senkrechte als auch parallele Magnetfeldkomponente sehr klein bzw. Null sind, kein Festfressen des Funken festgestellt werden.

Durch die mit einer erfindungsgemässen Arcquelle erzielbare **Richtwirkung** kann der erzeugte Plasmastrahl durch ein in der Kammer der Vakuumbehandlungsanlage zusätzlich erzeugtes Magnetfeld vorteilhaft gesteuert werden. Werden beispielsweise eine oder mehrere Arcquellen in Richtung der Achse einer Vakuumbehandlungsanlage angeordnet und gleichzeitig zumindest eine weitere konzentrisch zur Anlagenachse angeordnete elektromagnetische Spule vorgesehen, so kann damit der von der Arcquelle erzeugte Plasmastrahl abgelenkt werden. Wird die zumindest eine weitere Spule an einer zeitlich veränderlichen Stromquelle mit Steuereinheit angeschlossen, kann der Plasmastrahl variabel auf unterschiedliche Bereiche in der Kammer gerichtet werden. Beispielsweise kann der Plasmastrahl für Ätzprozesse an den Werkstücken vorbei oder für Beschichtungsprozesse bevorzugt periodisch über die Werkstücke geführt werden.

Dabei hat es sich zumindest bei symmetrischer Anordnung mehrere Quellen um eine Anlagenachse als vorteilhaft erwiesen, eine solche Spulenanordnung zu wählen, mit der ein möglichst gleichmässiges achsenparalleles Feld in der Kammer erzeugt werden kann. Dies wird beispielsweise duch eine Anlage mit zumindest zwei weiteren elektromagnetischen Spulen erreicht, bei der die weiteren Spulen bevorzugt im oberen sowie unteren bzw. den entsprechenden seitlich begrenzenden Bereichen der Anlage konzentrisch zur Anlagenachse angeordnet sind. Die Spulen können dabei einen unterschiedlichen oder einen im wesentlichen einer Helmholtzspulenanordnung entsprechend gleichen Durchmesser aufweisen.

Die Erfindung wird nun anhand schematischer Figuren beispielhaft beschrieben.
- FIG. 1: Arcquelle mit zwei Magnetsystemen.
- FIG. 2: Funkenverlauf auf Targetoberfläche.
- FIG. 3: Verlauf der Magnetfeldkomponenten nach dem Stand der Technik.
- FIG. 4: Magnetische Feldvektoren zu Fig. 3.
- FIG. 5: Verlauf der Magnetfeldkomponenten einer erfindungsgemässen Arcquelle.
- FIG. 6: Magnetische Feldvektoren zu Fig. 5.
- FIG. 7: Arcquelle mit einer umfassenden Spule.
- FIG. 8: Arcquelle mit Spule vor Target.
- FIG. 9: Schnitt durch eine Beschichtungsanlage.
- FIG. 10: Querschnitt einer Beschichtungsanlage mit 6 Quellen.
- FIG. 11: B_{┴}-Verlauf für optimalen Betrieb
- FIG. 12: B_{∥} -Verlauf für optimalen Betrieb
- FIG. 13: B_{┴}-Verlauf bei Funken in der Mitte
- FIG. 14: B_{∥} -Verlauf bei Funken in der Mitte
- FIG. 15: B_{┴}-Verlauf bei Funken am Rand
- FIG. 16: B_{∥} -Verlauf bei Funken am Rand

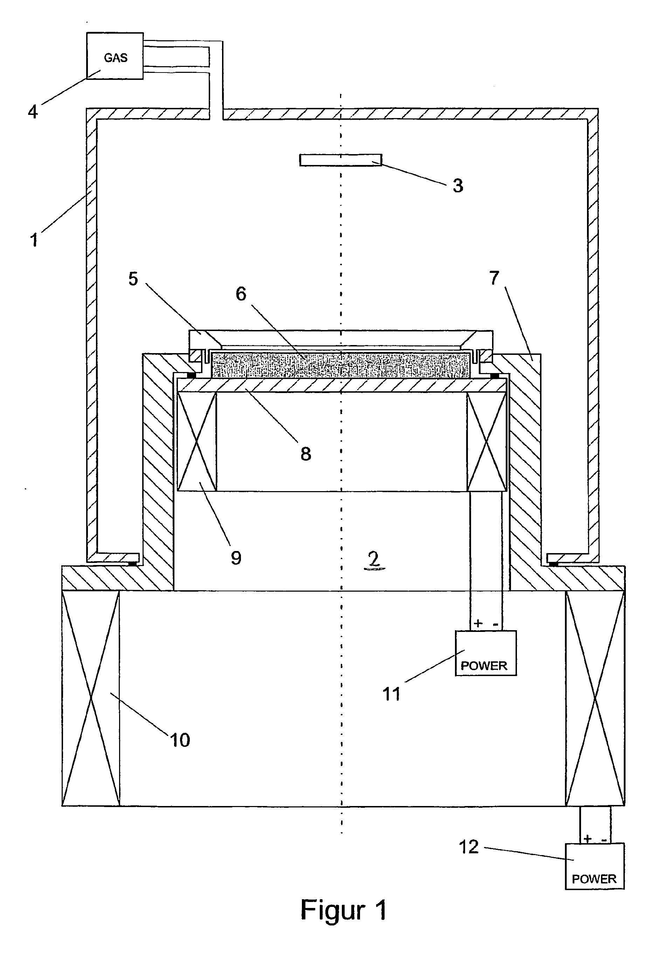

FIG. 1 zeigt eine in die Kammer einer mit Gasversorgung 4 und diversen hier nicht näher gezeigten Stromversorgungs-und Pumpeinheiten versehenen Vakuumbehandlungsanlage 1 eingebaute erfindungsgemässe Arcquelle 2, die auf ein Werkstück 3 wirkt. Bei der dargestellten Ausführung sind beide Magnetsysteme 9, 10 in Form elektromagnetischer Spulen ausgeführt und hinter dem Target 6, in bzw. an einem in Verbindung mit der Targetrückplatte 8 die Anlage gegen Atmosphäre abschliessenden Quelleneinschub 7 angeordnet. Die dem ersten Magnetsystem 9 zugeordnete erste Spule befindet sich direkt hinter dem Target 6, bzw. hinter einer in bekannter Weise wassergekühlten Targetrückplatte 8. Die dem zweiten Magnetsystem 10 zugeordnete zweite Spule ist ebenfalls hinter dem Target 6 angebracht, hat jedoch einen größeren Innen- sowie Aussendurchmesser als die erste Spule 9. Der Abstand zwischen erster Spule 9 und zweiter Spule 10 wurde dabei zwischen 0 und 200 mm, in einigen Ausführungsbeispielen auf 67 mm eingestellt. Beide Spulen befinden sich außerhalb der Kammer, sind damit leicht zugänglich und können, falls notwendig, auf einfache Weise gekühlt werden. Zur Versorgung der Spulen sind in diesem Fall zwei unabhängige Gleichspannungsversorgungen 11, 12 vorgesehen die den für den jeweiligen Prozess bzw. für das jeweilige Target geforderten Gleichstrom liefern.
Als Targets können beispielsweise Ronden mit einem Durchmesser von 160 mm und einer Dicke von 6 mm aus unterschiedlichen Werkstoffen wie z.B. Ti bzw. TiAl gefertigt werden. Grössere sowie kleinere Targetdicken sowie andere Formen sind wie dem Fachmann bekannt möglich. Die Spulengeometrie sowie eine beispielhafte Einstellung der Spulenströme sind aus Tabelle 1 ersichtlich. Um den gewünschten Effekt zu erreichen sind die beiden Spulen dabei so mit den Netzgeräten verschaltet, dass die durch die beiden Spulen fließenden Ströme elektrisch gegensinnig sind.

**Tabelle 1**

| Spule | Windungen | ∅ Leiter [mm] | I [A] | R* [Ω] | ∅ Innen [mm] | ∅ Aussen [mm] | Höhe [mm] |
|---|---|---|---|---|---|---|---|
| (1) | 1000 | 1 | 1,5 | 12,5 | 150 | 190 | 60 |
| (2) | 1500 | 1,5 | 5,0 | 14 | 260 | 320 | 130 |

| | | | | | | | |
|---|---|---|---|---|---|---|---|
| *Widerstand im kalten zustand. | | | | | | | |

Bevorzugte Betriebsparameter und Grenzwerte für den Betrieb einer entsprechenden Arcquelle sind in Tabelle 2 zusammengestellt (Targetdurchmesser ca. 160mm, d = 6-12mm, Targetwerkstoff: Ti bzw. TiAl).

**Tabelle 2**

| Parameter | Einheit | Bevorzugter Bereich | untere, obere Grenze |
|---|---|---|---|
| Druck | mbar | 10⁻⁴ -4x10⁻¹ | 10⁻⁴ -10⁻¹ |
| Bogenstrom | A | 150-210 | 40-250 |
| Bogenspannung | V | 20-35 | 10-100 |
| Verdampfungsrate | g/min | ca. 0.3 | bis ca. 0.4 |
| Substratabstand | mm | 200-300 | 100-550 |
| Beschichtungsdurchm.* | mm | 200 | 220 |

In Tabelle 3 sind zusätzlich zwei beispielhafte Betriebsarten zum Abscheiden von TiN bzw. TiAlN angeführt, wobei an die Substrate eine sogenannte Biasspannung angelegt wurde.

**Tabelle 3**

| | Bias [V] | Ar [sccm] | N₂ [sccm] | p [mbar] |
|---|---|---|---|---|
| TiN | 100 | 400 | 800 | 3,810⁻² |
| TiAIN | 40-150 | 400 | 800 | 3,810⁻² |

Die Versuche wurden auf einer RCS-Beschichtungsanlage der Firma Balzers mit oktogonalem Querschnitt und ca. 1000 1 Beschichtungsvolumen durchgeführt. Der Durchmesser Beschichtungskammer betrug 1070 mm, die Höhe 830 mm.

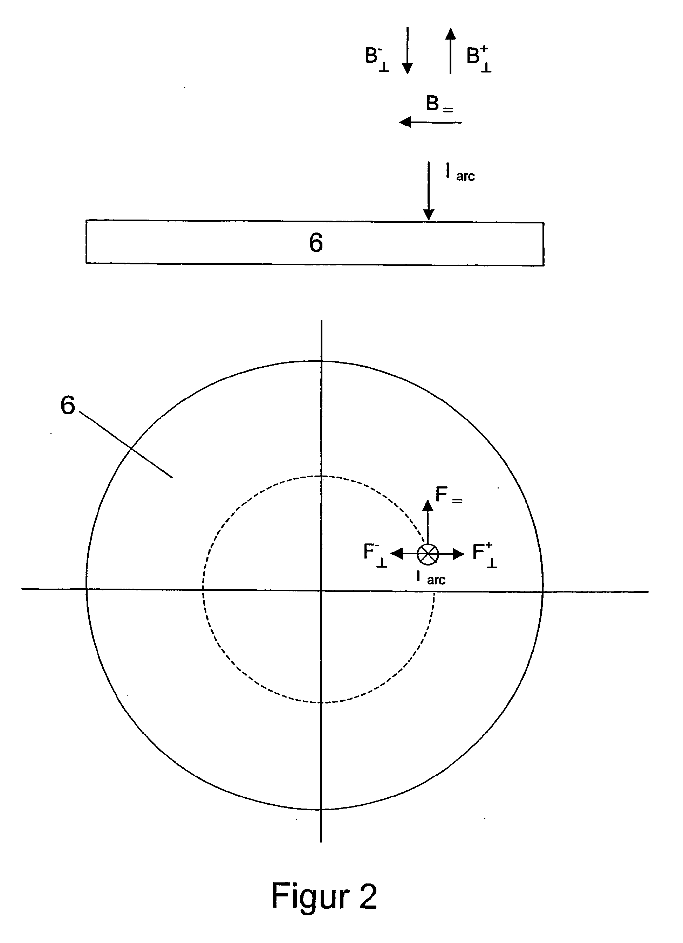

FIG. 2 zeigt schematisch am Beispiel eines kreisförmigen Targets 6 die auf einen Funken wirkenden Kräfte eines an der Targetoberfläche erzeugten radialsymmetrischen Magnetfelds. Der Funken wird dabei als bewegte Punktladung Q_{arc} betrachtet.
Generell wird ein im Magnetfeld bewegtes, geladenes Teilchen durch die Kraft F = Q (v x B) abgelenkt. Dabei ist F die auf eine im Magnetfeld bewegte Ladung Q wirkende Kraft, v die Geschwindigkeit der rechtwinklig zu den Feldlinien bewegten Ladung Q und B die magnetische Induktion des Feldes. Betrachtet man den im wesentlichen senkrecht auf die Targetoberfläche gerichteten Stromfluss I_{arc} eines Funkens unter Vernachlässigung des, gegenüber dem angelegten Magnetfeld, geringen Einflusses durch das elektromagnetische Feld der Targetkathode, so erfährt das geladene Teilchen durch eine zur Oberfläche parallele, und damit senkrecht zum Stromfluss I_{arc} gerichtete Kraft Fₗₗ eines radialsymmetrischen Magnetfeldes B ₗₗ eine Beschleunigung des Funkenverlaufs im rechten Winkel zur Feldlinie, d.h. je nach Feldrichtung im oder gegen den Uhrzeigersinn. Hingegen bewirkt eine senkrecht zur Targetoberfläche gerichtete Magnetfeldkomponente B_{┴}- bzw. B_{┴+} des äusseren Magnetfeldes zunächst keine Ablenkung der senkrecht eintretenden Ladungsträger des Stormflusses I_{arc}, da das Kreuzprodukt der Vektoren v x B hier Null ist. Erst nachdem der Funken durch die Ablenkung beim Eintreffen auf der Targetoberflächen eine wie beispielsweise in der Draufsicht gezeigte Ablenkung entgegen den Uhrzeigersinn erfährt und damit auch eine Geschwindigkeitskomponente parallel zur Targetoberfläche aufweist, wirken nun auch die beiden durch die senkrechten Magnetfeldkomponenten B_{┴-} und B_{┴+} erzeugten Kräfte F_{┴-} und F_{┴}+. Durch B_{┴-} wird der Funken wie dargestellt zur Targetmitte hin abgelenkt, B_{┴+} hingegen gibt dem Funken eine Geschwindigkeitskomponente die ihn zum Targetrand hin bewegt.

Dieser Effekt kann, wie bei der Würdigung des Standes der Technik erwähnt, durch eine Zweispulenanordnung mit einer zeitlich veränderlichen Stromzufuhr benutzt werden um den Funken entlang einer radial verschiebbaren Nulllinie der senkrechten Magnetfeldkomponente B_{⊥} über die Targetoberfläche zu führen.

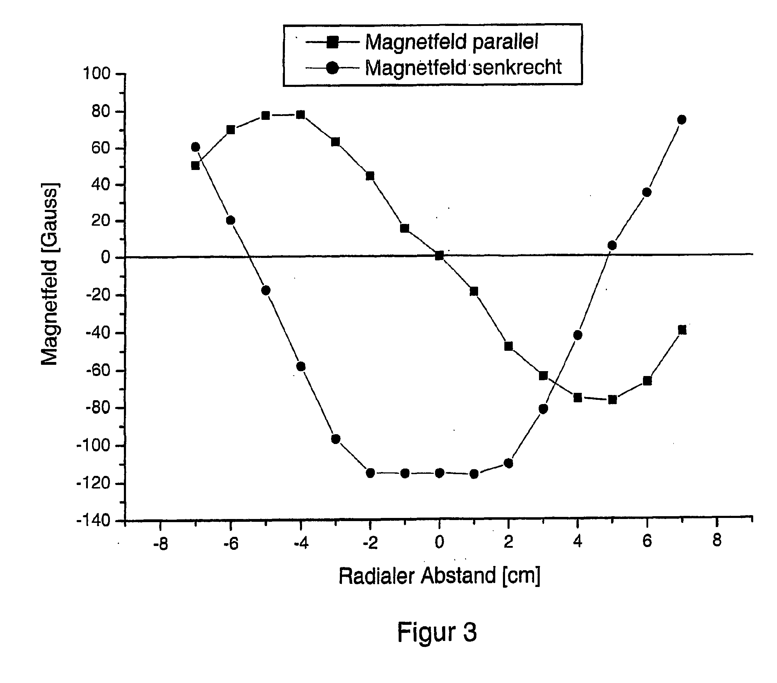

Als Beispiel für ein bekanntes durch Permanentmagnete aufgebautes Magnetfeld zeigt FIG. 3 dessen parallele sowie senkrechte Komponenten auf der Targetoberfläche. Bei dieser Magnetronanordnung sind auf der Rückseite des Targets im Randbereich umlaufend Magnete mit identischer Ausrichtung der Pole angebracht, denen ein oder mehrere entgegengesetzt gepolte Magnete im Zentrum des Targets gegenüberstehen. Im Vergleich zu Magnetronanordnungen für Sputtermagnetrons weisen die hier ähnlich angeordneten Magnete eine wesentlich geringere Feldstärke auf um den gewünschten Führungseffekt zu erreichen.

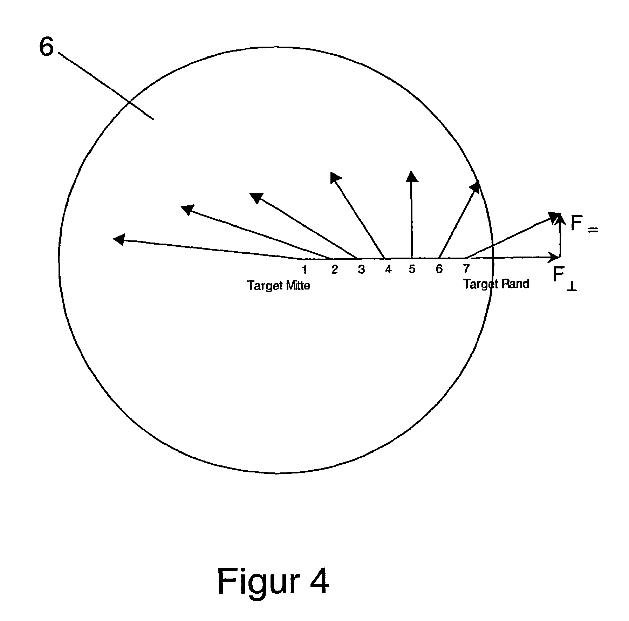

FIG. 4 zeigt die sich aus FIG. 3 ergebende vektorielle Darstellung der auf einen, senkrecht aus dem Plasma auf die Oberfläche brennenden, bzw. durch das parallele Magnetfeld kreisförmig abgelenkten Funken I_{arc} an den Positionen 1-7 der Targetoberfläche wirkenden Kraft. Dabei bewirkt B die tangential wirkende Kraft F_{∥}, B_{┴} eine dazu normal, also radial wirkende wirkende Kraft F_{┴} in der Targetebene. In der praktischen Anwendung zeigt sich, dass der Funkenverlauf im wesentlichen auf einem Kreissring in einem radialen Abstand von 4-6 cm von der Targetmitte verläuft und von dort periodisch in die Targetmitte kontrahiert. Dieser Verlauf des Funkens ergibt sich, da in einem radialen Abstand von 5 cm das senkrechte magnetische Feld Null ist, und das parallele Feld maximal. Durch das parallele Feld erfährt der Funken eine Bewegung in tangentialer Richtung wie in FIG. 2 gezeigt. Da das senkrechte Feld in einem radialen Abstand zwischen 4-6 cm unwesentlich von Null verschieden ist wird der Funken weder zur Tagetmitte noch zum Targetrand bewegt und läuft im wesentlichen im Bereich des erwähnten Kreisrings.
In der Targetmitte schneidet, wie in FIG. 3 dargestellt, die parallele Komponente des Magnetfelds jedoch die Nulllinie während die senkrechte Komponente ein Maximum durchläuft. Ein einmal aus der Führung des starken kreisringförmingen parallellen Magnetfelds in Richtung der Targetmitte entkommener Funke erfährt dort keine oder zumindest nur noch eine geringe Ablenkung, da der senkrecht einfallende Funken durch die schwache Kraft F_{∥} kaum beschleunigt wird, weshalb sich die grosse Kraft F_{⊥} kaum auswirkt. Daher verlangsamt der Funke im zentralen Bereich seine Bewegung über die Targetoberfläche und erhitzt diese lokal so stark, dass Targetmaterial explosionsartig verdampft, worauf der Funken erlischt. Dies führt auch zu einer erhöhten Emission neutraler Teilchen (Spritzer) und erhöhtem Targetabtrag im Mittelbereich des Targets. Dieser Verlauf des Funkens erweist sich in der Praxis auch deshalb als ungünstig, da nur ein verhältnismässig kleiner Teil der Targetoberfläche abgetragen wird, was zur Ausbildung von Erosionsprofilen und d.h. häufigem Targetwechsel führt um die mechanische Stabilität des Targets zu erhalten. Somit kann nur ein Bruchteil des häufig kostspieligen Targetmaterials vor Ende der Targetlebensdauer verdampft werden.

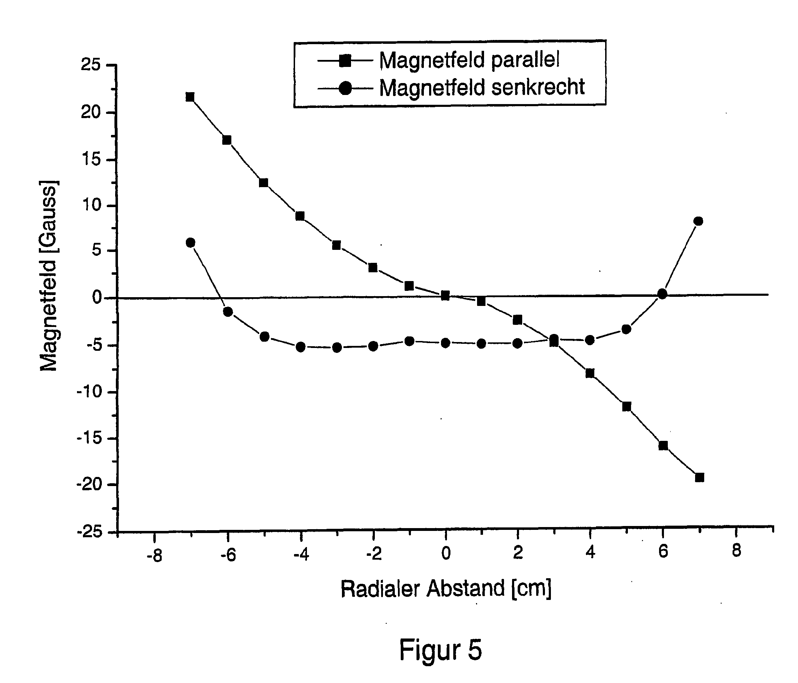

In FIG. 5 wird der Verlauf der senkrechten B_{⊥} und parallelen B_{∥} Komponenten eines erfindungsgemässen Magnetfeldes dagestellt, wie es beispielsweise durch eine in FIG. 1 beschriebene Arcquelle an der Targeoberfläche, bzw. unmittelbar davor durch Superposition der zwei Spulenfelder erzeugt wird. Dabei wurden die Spulenströme entsprechend Tabelle 1 konstant zu 1,5 A eingestellt.
Das dadurch erzeugte Magnetfeld zeichnet sich durch einen Verlauf der senkrechten Komponente aus, der anders als in FIG. 3, über einen weiten Bereich konstant ist und deutlich kleinere Werte aufweist. So verläuft die senkrechte Komponente B_{⊥} hier zwischen +5 und -5 Gauss, wohingegen die senkrechte Komponente in FIG. 3 zwischen +80 und -120 Gauss, mit einem ausgeprägtem Minimum im zentralen Bereich verläuft. Auch die in FIG. 5 dargestellt parallele Komponente B_{∥} ist insgesamt schwächer als die in FIG. 3. Von einem Wert von ca. 20 Gauss am Targetrand beginnend verläuft B_{∥} mit einem Gradienten von etwa 4 Gauss/cm, quasi linear bis in die Nähe des Wendepunkts (entspricht einem Minimum in Polarkoordinatendarstellung). Erst in dessen unmittelbarer Umgebung flacht die Kurve deutlich ab. Die Ausbildung einer oder mehrerer B_{⊥}-Nulllinien in Verbindung mit maximalen B_{∥} -Werten wird dabei durch eine erste Spule, deren Innendurchmesser in etwa der Targetprojektion entspricht, bewusst vermieden, womit der Funken nicht auf eine bevorzugte Bahn gezwungen und die Ausbildung von ausgeprägten Abtragungsprofilen, wie beispielsweise umlaufende Racetracks, vermieden wird. Ähnliche Magnetfelder können auch in bekannter Weise durch Permanentmagnete erzeugt werden.

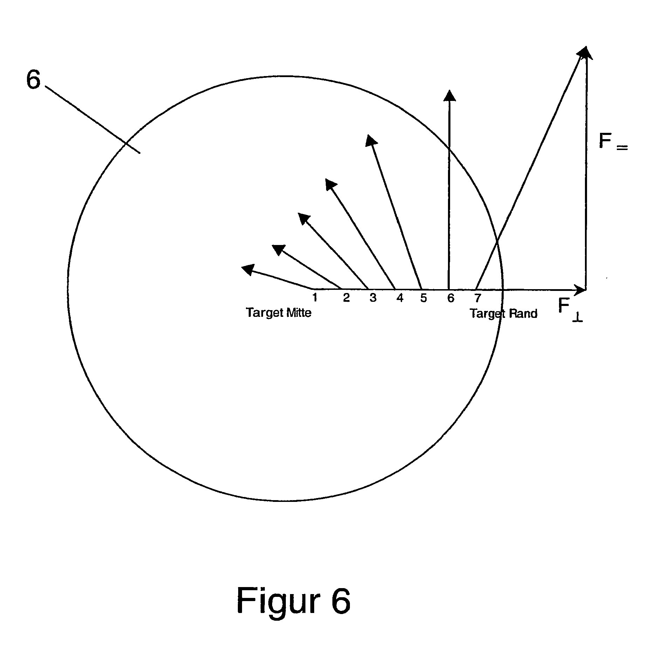

FIG. 6 zeigt analog zu FIG. 4 eine vektorielle Darstellung der durch eine erfindungsgemässe Arcquelle, wie unter FIG. 1 beschrieben, an den Positionen 1-7 der Targetoberfläche auf einen Funken wirkenden Kraft. Dies könnte auch erklären, wieso ein erfindungsgemäss ausgeführtes bzw. betriebenes Magnetsystem wirksam verhindert, dass sich der Funken in schädlicher Weise zur Targetmitte hin kontrahiert. Durch die nach Aussen im wesentlichen kontinuierlich ansteigende paralelle Kraftkomponente Fₗₗ bekommt der Funken eine relative konstante Winkelgeschwindigkeit über den gesamten radialen Bereich des Targets, der Funken läuft also umso schneller, je weiter er von der Targetmitte entfernt ist. Gleichzeitig ist die im mittleren Bereich wirkende zentripetale Kraftkomponente F₁ geringer als die in FIG. 4.
Beim Betrieb einer solchen Arcquelle lässt sich beobachten, dass es zu einer feinen Verästelung des Arcstroms in viele kleine Funken kommt, die den gesamten Bereich des Targets ablaufen. Weiters bildet das durch Überlagerung der beiden Spulenfelder entstandene Magnetfeld ein Fernfeld, das eine Bündelung des Plasmas zu einem Plasma-Jet bewirkt, der seinerseits durch zusätzliche Spulen abgelenkt werden kann. Da bei gleicher Targetleistung der Abtrag zumindest ebenso gross ist wie bei herkömmlichen Arcquellen, kommt es bei Ausrichtung des Ionenstroms in Richtung der Werkstücke 3 zu einer höheren Beschichtungsrate. Diese Bündelung kann entsprechend den Anforderungen in weitem Umfang, beispielsweise durch Einstellen der Spulenströme auf die jeweiligen insbesondere geometrischen Verhältnisse wie beispielsweise gewünschte Beschichtungshöhe, Substrattargetabstand etc. eingstellt werden.

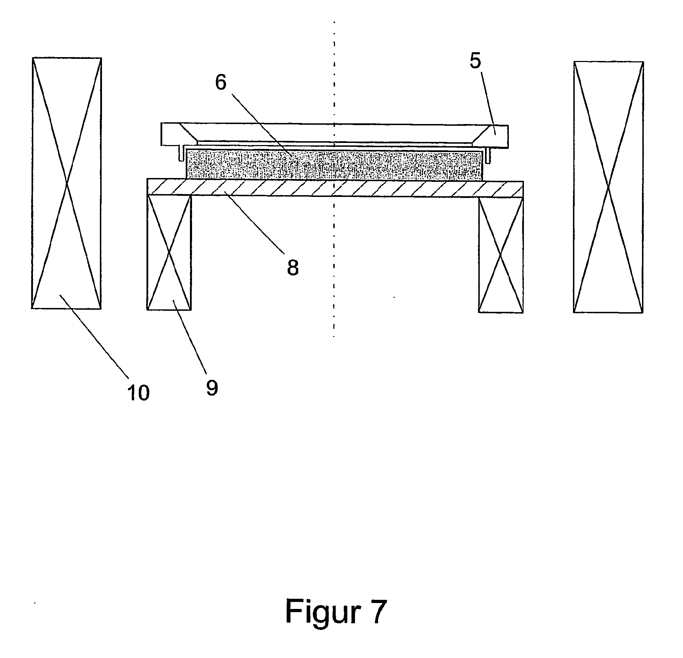

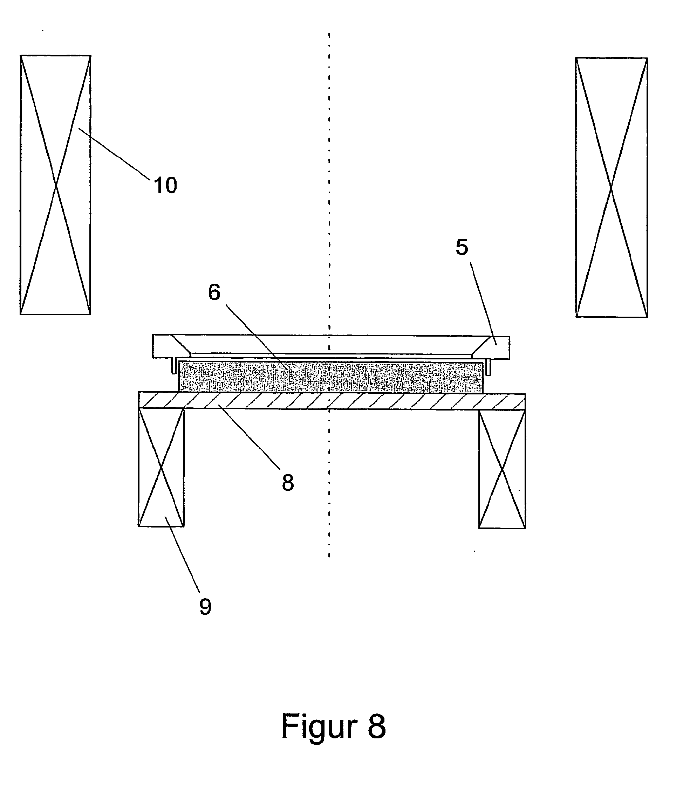

FIG. 7 und FIG. 8 zeigen zwei weitere Ausführungen einer erfindungsgemässen Arcquelle, wobei in FIG. 7 das zweite Magnetsystem 10 das erste Magnetsystem 9 umfasst, während in FIG. 8 das zweite Magnetsystem 10 vor dem Target 6 angeordnet ist. Bei einer, wie in FIG. 8 gezeigten Arcquelle kann das zweite Magnetsystem auch ähnliche Abmessungen wie das erste System aufweisen, insbesondere wenn erstes und zweites System wirkungssymmetrisch gegenüber dem Target angeordnet sind, und die Inndurchmesser zumindest gleich oder grösser den Ausenabmessungen des Targtes gewählt werden.

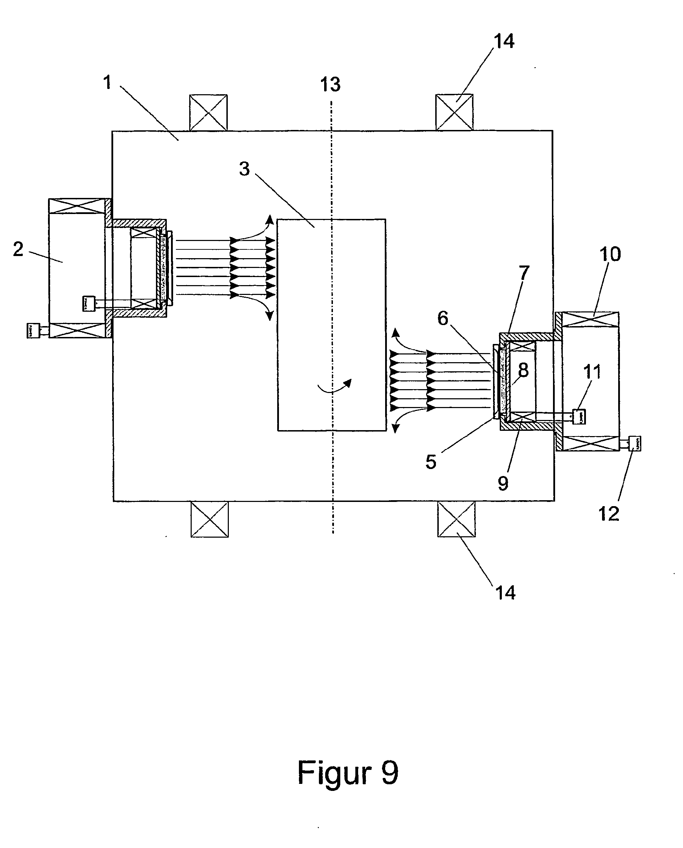

FIG. 9 zeigt eine Vakuumbehandlungsanlage 1 mit Arcquellen 2, die seitlich auf ein oder mehrere um die Anlagenachse 13 bewegte Werkstücke 3 wirken. Zur vertikalen Ablenkung des Plasmastrahls sind weitere Spulen 14 in Helmholtzanordnung vorgesehen.

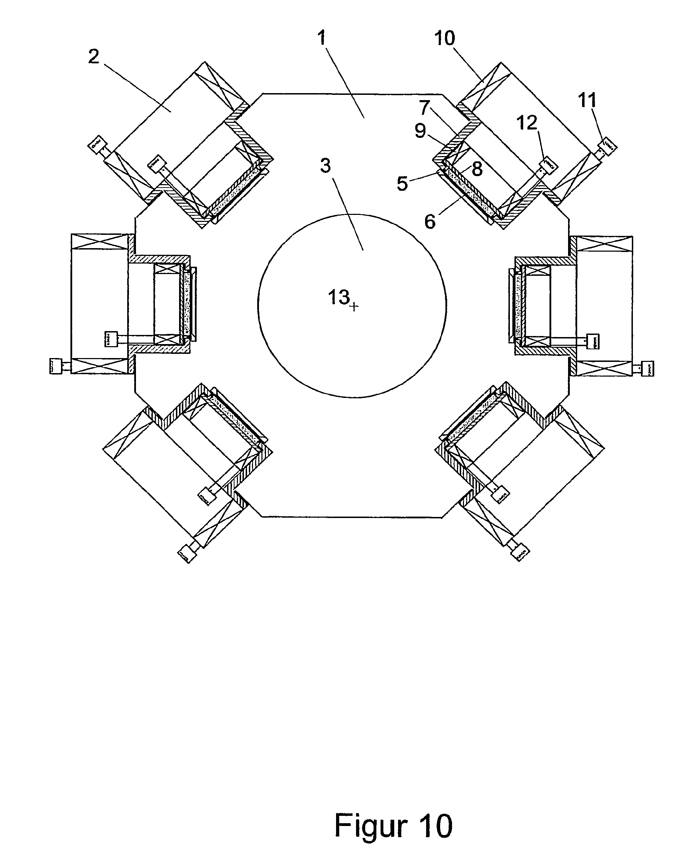

FIG. 10 zeigt eine Beschichtungsanlage 1.mit 6 Arcuellen 2 im Querschnitt, bei der alle Quellen 2 im wesentlichen rechtwinklig in Richtung der Anlagenachse 13 ausgerichtet sind.

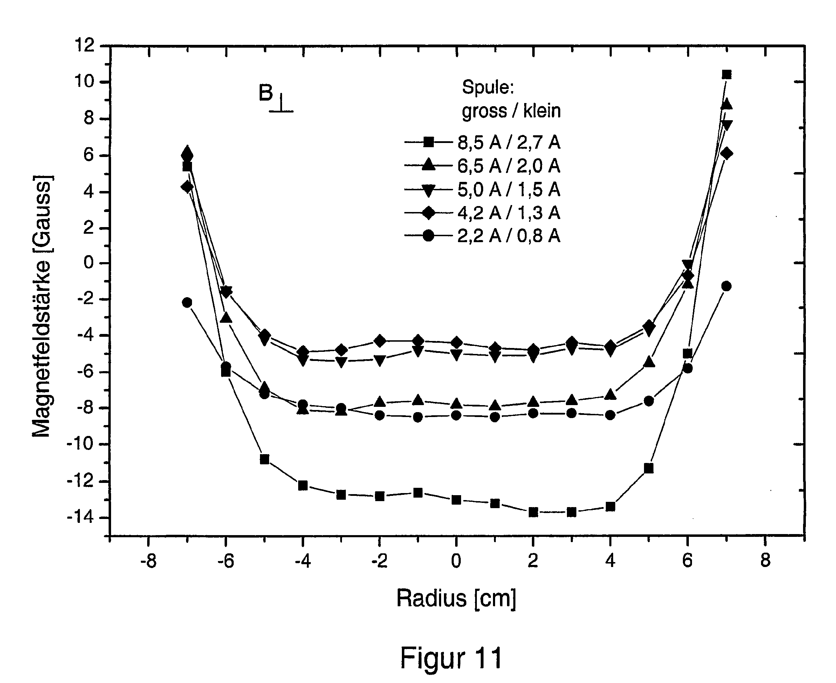

FIG. 11 bis FIG. 16 zeigen die bei verschiedener Einstellung der Spulenströme erzeugten Verläufe der B_{⊥}- bzw. B_{∥} - Komponente des Magnetfelds an der Targetoberfläche. Die Arcquellen wurden dabei entsprechend der bei FIG. 1 beschriebenen Betriebsparametern betrieben um optimale Einstellungsbereiche und Grenzen zu ermitteln.

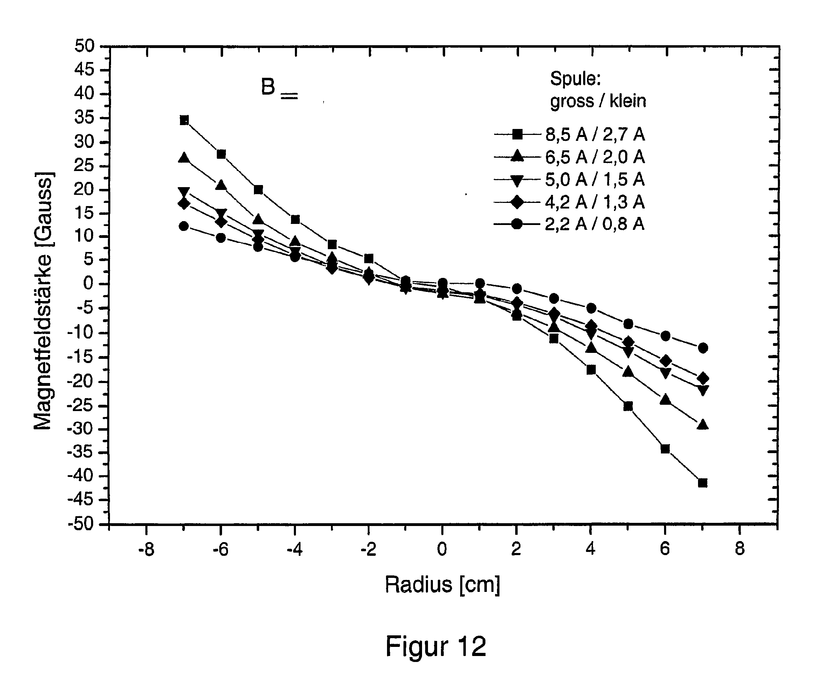

So zeigen FIG. 11 und 12 verschiedene mit entsprechenden Spuleneinstellungen korrespondierende B_{⊥}- bzw. B _{∥} -Kurven des Magnetfelds bei denen ein erwünschter feinverteilter Funkenverlauf erzielt werden konnte. Zu beachten ist hierbei, dass B_{┴}- bzw. B_{∥} -Werte bei gegebener geometrischer Konfiguration nicht unabhängig voneinander eingestellt werden können, weshalb einer B_{┴}-Verteilung in FIG. 11 jeweils nur eine gleich bezeichnete Bₗₗ -Verteilung in FIG. 12 entspricht.

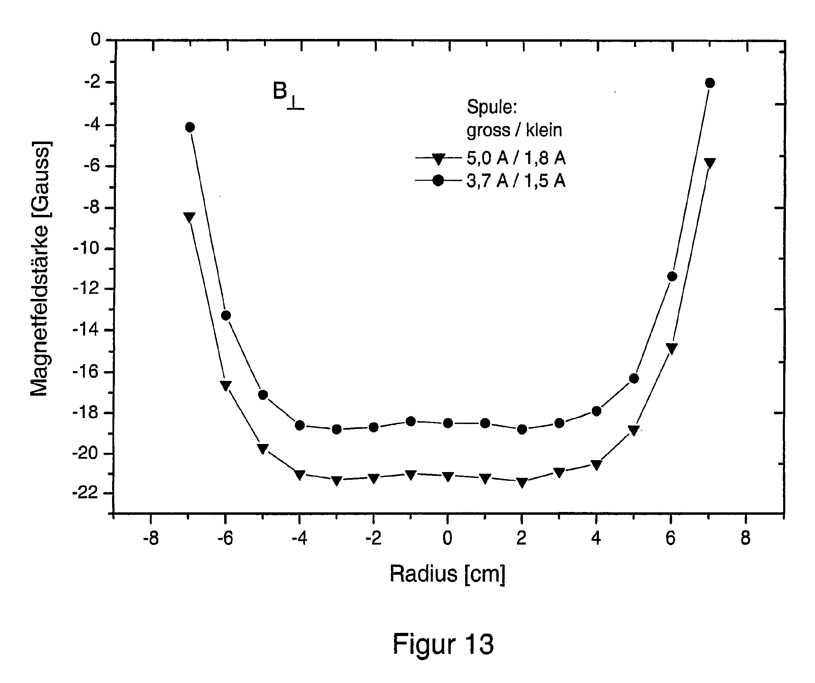

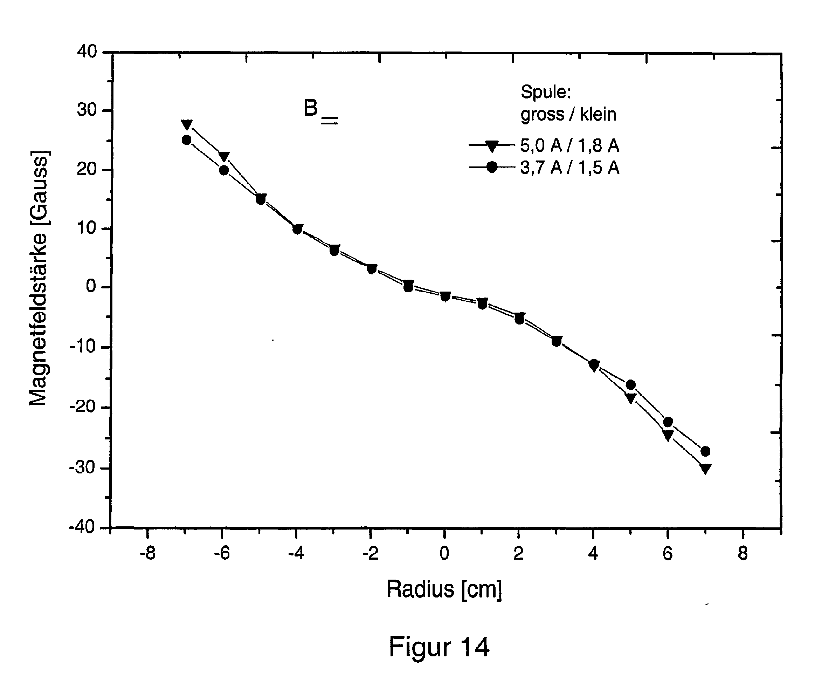

FIG. 13 und 14 zeigen einen Grenzfall, in dem der Bogen zwar noch feinverteilt läuft, aber bereits mit freiem Auge erste Anzeichen einer periodischen Kontraktion in die Mitte zu erkennen sind. Wird die B_{⊥}-Verteilung noch deutlich weiter zu negativen Werten verschoben, kommt es zu einem gröberen Funkenverlauf und einer zu starken Kontraktion in den Mittenbereich.

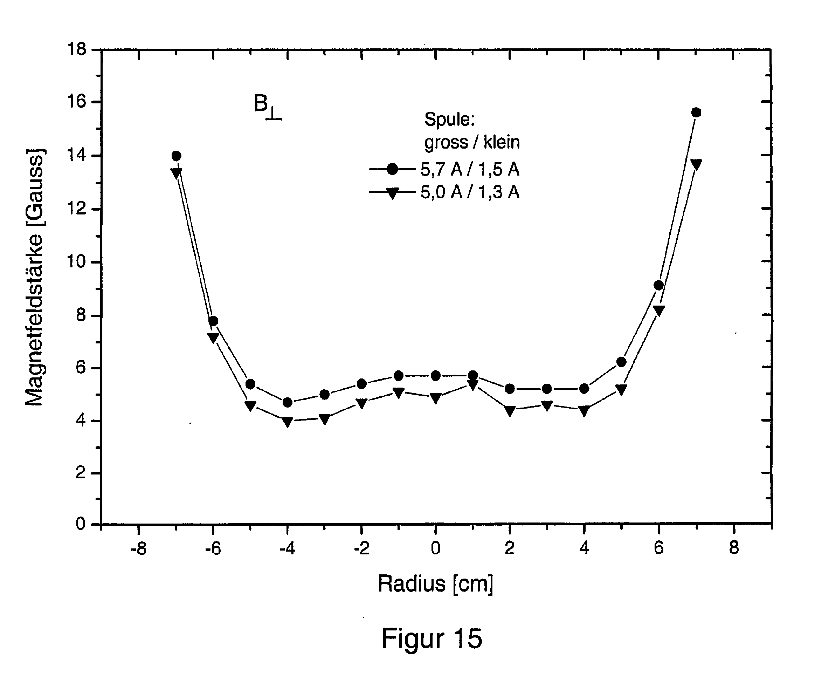

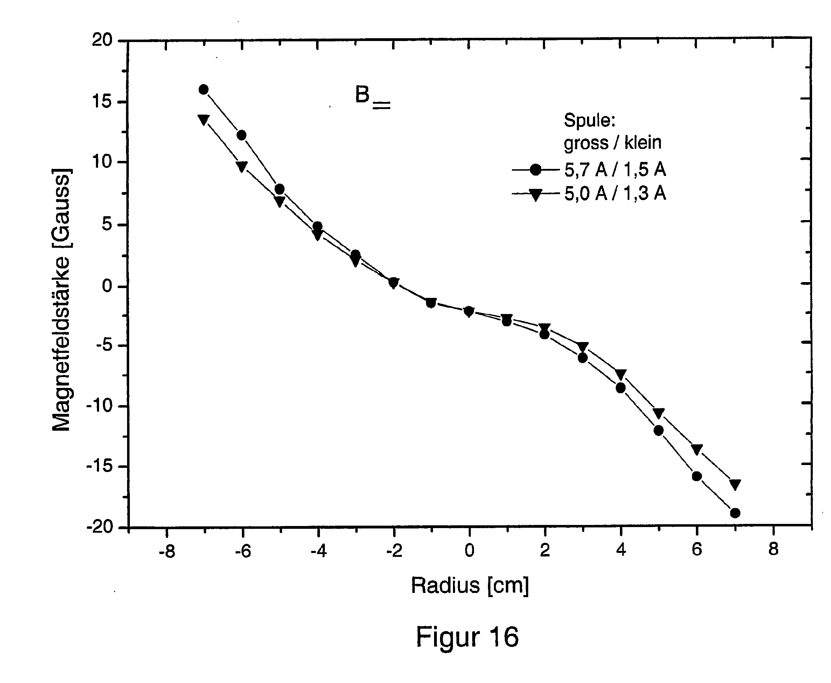

FIG. 15 und 16 zeigen einen weiteren Grenzfall. Auch hier ist das Funkenmuster noch ausreichend feinverteilt, jedoch sind durch das hierbei angelegt Magnetfeld erste Anzeichen eines periodischen Abdrängens des Funkens in den Randbereich des Targets zu erkennen. Wird die B_{⊥}-Verteilung noch deutlich weiter zu positiven Werten verschoben, kommt es zu einem gröberen Funkenverlauf am Rand des Targets.

Weiters wurde festgestellt, dass B_{┴}-Verteilung die auf beiden Seiten der Nullinie liegen höhere Differenzen der Magnetfeldstärke, d.h. eine ungleichmässigere B_{⊥}-Verteilung an der Targetoberfläche, bei annähernd gleichbleibend fein-und gleichmässig verteilten Funkenverlauf erlauben, als B_{⊥}-Verteilung die vollständig über bzw. unter der Nullinie liegen.

## Patentansprüche

1. Vakuumarcquelle, umfassend ein Target mit einer Oberfläche zum Betreiben einer Lichtbogenentladung, wobei das Target im Wirkungsbereich einer Magnetfelderzeugungsvorrichtung angeordnet ist
**dadurch gekennzeichnet, dass**
die Magnetfelderzeugungsvorrichtung aus zumindest zwei entgegengesetzt gepolten Magnetsystemen besteht und so ausgebildet ist, dass die senkrecht zur Oberfläche stehende Komponente B_{⊥} des Magnetfelds über einen Grossteil der Oberfläche im wesentlichen konstant kleine Werte kleiner 30 Gauss aufweist oder Null ist.

2. Arcquelle nach Anspruch 1, **dadurch gekennzeichnet, dass** der Wert der senkrechten Magnetfeldkomponente B_{┴} kleiner 20, bevorzugt kleiner 10 Gauss ist.

3. Arcquelle nach einem der vorhergehenden Ansprüche, **dadurch gekennzeichnet, dass** der Grossteil der Oberfläche sich von einem Mittenbereich der Targetoberfläche bis in einen Randbereich erstreckt, und zwar so, dass der Grossteil zumindest 50%, insbesondere bevorzugt 60% oder mehr des oder der geometrisch bestimmenden Maße der Targetoberfläche umfasst.

4. Arcquelle nach einem der vorhergehenden Ansprüche, **dadurch gekennzeichnet, dass** im Randbereich der Targetoberfläche die Werte B_{┴R} der senkrechte Magnetfeldkomponente gegenüber den Werten B_{┴M} im Mittenbereich der Targetoberfläche ansteigend, fallend und/oder das Vorzeichen wechseln.

5. Arcquelle nach einem der vorhergehenden Ansprüche, **dadurch gekennzeichnet, dass** der Wert der parallelen Magnetfelkomponente B_{∥} in der Mitte im wesentlichen Null und in Richtung des Randes der Targetoberfläche ansteigend oder abfallend, bevorzugt symmetrisch gegenüber der Targetmitte, insbesondere bevorzugt im wesentlichen linear ansteigend ist.

6. Arcquelle nach einem der vorhergehenden Ansprüche, **dadurch gekennzeichnet, dass** das erste der zumindest zwei entgegengesetzt gepolten Magnetsysteme zumindest eine hinter dem Target angebrachte erste elektromagnetische Spule umfasst.

7. Arcquelle nach Anspruch 6, **dadurch gekennzeichnet, dass** die Innenabmessungen der ersten Spule sich im wesentlichen mit einer Abweichung von höchstens plus/minus 30%, bevorzugt plus/minus 20% mit der Projektion der Aussenabmessungen der Oberfläche decken.

8. Arcquelle nach einem der Ansprüche 1 bis 5, **dadurch gekennzeichnet, dass** das erste der zumindest zwei entgegengesetzt gepolten Magnetsysteme aus einem oder mehreren hinter dem Target angebrachten Permanentmagneten besteht.

9. Arcquelle nach Anspruch 8, **dadurch gekennzeichnet, dass** der oder die Permanentmagneten entweder selbst eine geringe Feldstärke aufweisen, oder einen solchen Abstand vom Target haben, dass die Feldstärke an der Targetoberfläche gering ist.

10. Arcquelle nach einem der vorhergehenden Ansprüche, **dadurch gekennzeichnet, dass** das zweite der zumindest zwei entgegengesetzt gepolten Magnetsysteme zumindest eine zweite zum ersten Magnetsystem koaxial angeordnete Spule umfasst.

11. Arcquelle nach Anspruch 10, **dadurch gekennzeichnet, dass** die zweite Spule, hinter dem ersten Magnetsystem angeordnet ist.

12. Arcquelle nach Anspruch 10, **dadurch gekennzeichnet, dass** die zweite Spule in einem Abstand vor dem Target angeordnet ist.

13. Arcquelle nach Anspruch 10, **dadurch gekennzeichnet, dass** die zweite Spule das erste Magnetsystem zumindest teilweise koaxial umfasst.

14. Arcquelle nach einem der Ansprüche 10 bis 13, **dadurch gekennzeichnet, dass** die zweite Spule eine höhere Windungszahl und/oder einen grösseren Durchmesser als die erste Spule aufweist.

15. Arcquelle nach einem der vorhergehenden Ansprüche, **dadurch gekennzeichnet, dass** das Target als Kathode geschaltet ist.

16. Arcquelle nach einem der vorhergehenden Ansprüche **dadurch gekennzeichnet, dass** das Target als Anode geschaltet ist.

17. Vakuumanlage, in der zumindest eine Arcquelle nach einem der Ansprüche 1 bis 16 angeordnet ist.

18. Anlage nach Anspruch 17, **dadurch gekennzeichnet, dass** die mindestens eine Arcquelle in Richtung der Anlagenachse wirkt und zumindest eine weitere konzentrisch zur Anlagenachse angeordnete elektromagnetische Spule aufweist um den erzeugten Plasmastrahl abzulenken.

19. Anlage gemäss Anspruch 18, **dadurch gekennzeichnet, dass** die zumindest eine weitere Spule an zumindest einer zeitlich veränderlichen Stromquelle mit Steuereinheit angeschlossen ist, um die Ausrichtung des durch die mindestens eine Arcquelle erzeugten Plasmastrahls variabel abzulenken.

20. Anlage nach einem der Ansprüche 18 bis 19, **dadurch gekennzeichnet, dass** zumindest zwei weitere elektromagnetische Spulen, bevorzugt im oberen sowie unteren bzw. den entsprechenden seitlich begrenzenden Bereichen der Anlage konzentrisch zur Anlagenachse angeordnet sind, die einen unterschiedlichen oder gleichen Durchmesser bzw. einen im wesentlichen einer Helmholzspulenanordnung entsprechenden Aufbau aufweisen.

21. Verfahren zum Betreiben einer Lichtbogenentladung an der Targetoberfläche einer Arcquelle mit Hilfe einer Magnetfelderzeugungsvorrichtung, **dadurch gekennzeichnet, dass** mit der Magnetfelderzeugungsvorrichtung aus zumindest zwei entgegengesetzt gepolten Magnetsystemen an der Oberfläche ein Magnetfeld so erzeugt wird, dass dessen senkrechte Komponente B_{⊥} über einen Grossteil der Oberfläche im wesentlichen konstant kleine werte kleiner als 30 Gauss aufweist oder Null ist.

22. Verfahren gemäss Anspruch 21, **dadurch gekennzeichnet, dass** der Wert B_{⊥} der senkrechte Magnetfeldkomponente kleiner 30, bevorzugt kleiner 20, insbesondere bevorzugt kleiner 10 Gauss eingestellt wird.

23. Verfahren nach einem der Ansprüche 21 bis 22, **dadurch gekennzeichnet, dass** das Magnetfeld so eingestellt wird, dass sich der Grossteil der Oberfläche mit im wesentlichen konstant nahe oder bei Null verlaufender senkrechter Komponente B_{⊥} von einem Mittenbereich der Targetoberfläche bis zu einem Randbereich erstreckt, und zwar so, dass der Mittenbereich zumindest 50%, insbesonders bevorzugt 60% oder mehr des oder der geometrisch bestimmenden Maße der Targetoberfläche umfasst.

24. Verfahren nach einem der Ansprüche 21 bis 23, **dadurch gekennzeichnet, dass** im Randbereich der Targetoberfläche die Werte B_{┴R} der senkrechte Magnetfelkomponente gegenüber den Werten B_{┴M} im Mittenbereich der Targetoberfläche ansteigend, fallend und/oder das Vorzeichen wechselnd eingestellt werden.

25. Verfahren nach einem der Ansprüche 21 bis 24, **dadurch gekennzeichnet, dass** der Wert der parallelen Magnetfelkomponente B_{∥} in der Mitte im wesentlichen auf Null und in Richtung des Randes der Targetoberfläche ansteigend, bevorzugt symmetrisch gegenüber der Targetmitte ansteigend, eingestellt wird, sodass die auf den Funken tangential im oder gegen den Uhrzeigersinn wirkende Kraft gegen den Rand des Targets ansteigt.

26. Verfahren nach einem der Ansprüche 21 bis 24, **dadurch gekennzeichnet, dass** zusätzlich in einem Bereich vor dem Target ein im wesentlichen senkrecht zur Oberfläche gerichtetes magnetisches Fernfeld erzeugt wird.

27. Verfahren nach einem der Ansprüche 21 bis 26, **dadurch gekennzeichnet, dass** die Magnetfeldstärke entsprechend dem Targetmaterial und/oder Targetdicke eingestellt wird.

28. Verfahren nach einem der Ansprüche 21 bis 27, **dadurch gekennzeichnet, dass** die Magnetfelderzeugungsvorrichtung zumindest eine hinter dem Target angeordnete Spule umfasst und zum Einstellen des Magnetfelds eine Spannungsquelle an die zumindest eine Spule angelegt wird, sodass ein Strom in eine erste Richtung fliesst.

29. Verfahren nach einem der Ansprüche 21 bis 27, **dadurch gekennzeichnet, dass** die Magnetfelderzeugungsvorrichtung zumindest ein hinter dem Target angeordnetes aus einem oder mehreren Permanentmagneten aufgebautes Magnetsystem umfasst.

30. Verfahren nach einem der Ansprüche 28 bis 29, **dadurch gekennzeichnet, dass** zumindest eine zweite Spule hinter, vor oder das Target umfassend angeordnet ist und zum Einstellen des Magnetfelds eine Spannung so an die zweite Spule angelegt wird, dass ein dem durch das erste Magnetsystem erzeugte Magnetfeld entgegengesetzt gerichtetes zweite Magnetfeld erzeugt wird.

31. Verfahren zum Beschichten eines Werkstücks, insbesondere eines Werkzeugs und/oder eines Bauteils unter Verwendung eines der Verfahren gemäss Ansprüchen 20 bis 29.

32. Verfahren zum Beschichten eines Werkstücks, insbesondere eines Werkzeugs und/oder eines Bauteils unter Verwendung einer Arcquelle gemäss Ansprüchen 1 bis 16.

## Claims

1. Vacuum arc source comprising a target with a surface for operating an arc discharge, wherein the target is arranged in the effective area of a device producing a magnetic field, **characterised in that** the device producing the magnetic field comprises at least two magnet systems with opposite poles and is designed so that the component B_{┴} of the magnetic field standing perpendicular to the surface has substantially constant low values of less than 30 Gauss or zero over a large part of the surface.

2. Arc source according to claim 1, **characterised in that** the value of the perpendicular magnetic field component B_{┴} is less than 20, preferably less than 10 Gauss.

3. Arc source according to any preceding claims, **characterised in that** the large part of the surface extends from a middle area of the target surface to an edge zone, such that the large part includes at least 50%, particularly preferably 60% or more of the geometrically decisive mass of the target surface.

4. Arc source according to any of the preceding claims, **characterised in that** in the edge zone of the target surface, the values B_{┴R} of the perpendicular magnetic field component rise, fall and/or change signs compared with the values B_{┴M} in the middle area of the target surface.

5. Arc source according to any of the preceding claims, **characterised in that** the value of the parallel magnetic field component B_{∥} is substantially zero in the middle and rises or falls in the direction of the edge of the target surface, preferably symmetrically in relation to the target centre, particularly preferably rises substantially linearly.

6. Arc source according to any of the preceding claims, **characterised in that** the first of the at least two magnet systems with opposite poles comprises at least one first electromagnetic coil placed behind the target.

7. Arc source according to claim 6, **characterised in that** the inner dimensions of the first coil substantially coincide, with a deviation of maximum plus/minus 30%, preferably plus/minus 20%, with the projection of the outer dimensions of the surface.

8. Arc source according to any of claims 1 to 5, **characterised in that** the first of the at least two magnet systems with opposite poles comprises one or more permanent magnets placed behind the target.

9. Arc source according to claim 8, **characterised in that** the permanent magnet or magnets either themselves have low field strength, or have a distance from the target such that the field strength at the target surface is low.

10. Arc source according to any of the preceding claims, **characterised in that** the second of the at least two magnet systems with opposite poles comprises at least one second coil arranged coaxially to the first magnet system.

11. Arc source according to claim 10, **characterised in that** the second coil is arranged behind the first magnet system.

12. Arc source according to claim 10, **characterised in that** the second coil is arranged at a distance in front of the target.

13. Arc source according to claim 10, **characterised in that** the second coil surrounds the first magnet system at least partly coaxially.

14. Arc source according to any of claims 10 to 13, **characterised in that** the second coil has a higher number of windings and/or a larger diameter than the first coil.

15. Arc source according to any of the preceding claims, **characterised in that** the target is connected as a cathode.

16. Arc source according to any of the preceding claims, **characterised in that** the target is connected as an anode.

17. Vacuum system in which at least one arc source is arranged according to any of claims 1 to 16.

18. System according to claim 17, **characterised in that** the at least one arc source acts in the direction of the system axis and has at least one further electromagnetic coil arranged concentrically to the system axis in order to deflect the plasma beam produced.

19. System according to claim 18, **characterised in that** the at least one further coil is connected to at least one temporally varying current source with a control unit in order to deflect variably the alignment of the plasma beam produced by the at least one arc source.

20. System according to one of claims 18 to 19, **characterised in that** at least two further electromagnetic coils, preferably in the upper and lower or corresponding laterally ajacent areas of the system, are arranged concentrically to the system axis and have a different or the same diameter or a design substantially corresponding to a Helmholz coil arrangement.

21. Method for operating an arc discharge on the target surface of an arc source using a device producing a magnetic field, **characterised in that** the device for producing a magnetic field generates a magnetic field on the surface such that its perpendicular component B_{┴} over a large part of the surface has a substantially constantly low value of less than 30 Gauss or zero.

22. Method according to claim 21, **characterised in that** the value B_{┴} of the perpendicular magnetic field component is set less than 30, preferably less than 20, particularly preferably less than 10 Gauss.

23. Method according to one of claims 21 to 22, **characterised in that** the magnetic field is set so that the large part of the surface with component B_{⊥} running perpendicularly substantially constantly near or at zero extends from the middle area of the target surface to an edge zone, such that the middle area comprises at least 50%, particularly preferably 60% or more of the geometrically decisive mass of the target surface.

24. Method according to any of claims 21 to 23, **characterised in that** in the edge zone of the target surface the values B_{┴R} of the perpendicular magnetic field component are set to rise, fall and/or change signs compared with the values B_{┴M} in the middle area of the target surface.

25. Method according to any of claims 21 to 24, **characterised in that** the value of the parallel magnetic field component Bₗₗ is set substantially at zero in the middle and rises in the direction of the edge zone of the target surface, preferably symmetrically in relation to the middle of the target, so that the force acting tangentially on the spark clockwise or counter-clockwise rises toward the edge zone of the target.

26. Method according to any of claims 21 to 24, **characterised in that** a magnetic field aligned substantially perpendicular to the surface is also produced in an area in front of the target.

27. Method according to any of claims 21 to 26, **characterised in that** the magnetic field strength is set corresponding to the target material and/or target thickness.

28. Method according to any of claims 21 to 27, **characterised in that** the device producing the magnetic field comprises at least one coil placed behind the target, and a voltage source is applied to at least one coil to adjust the magnetic field, so that current flows in a first direction.

29. Method according to any of claims 21 to 27, **characterised in that** the device for producing the magnetic field comprises at least one magnet system constructed from of one or more permanent magnets and arranged behind the target.

30. Method according to any of claims 28 to 29, **characterised in that** at least one second coil is placed behind, in front of or around the target, and to adjust the magnetic field a voltage is applied to the second coil such that a second magnetic field is produced that is aligned opposite the magnetic field produced by the first magnet system.

31. Method for coating a workpiece, in particular a tool and/or a component, using one of the methods in claims 20 to 29.

32. Method for coating a workpiece, in particular a tool and/or a component, using an arc source according to claims 1 to 16.

## Revendications

1. Source d'arc sous vide, comprenant une cible présentant une surface destinée à l'exploitation d'une décharge en arc, la cible étant disposée dans la région d'action d'un dispositif de génération de champ magnétique,
**caractérisée en ce que**
le dispositif de génération de champ magnétique est constitué d'au moins deux systèmes magnétiques de polarités opposées et est conformé de sorte que la composante du champ magnétique B_{┴}, laquelle est perpendiculaire à la surface, a des valeurs petites sensiblement constantes inférieures à 30 Gauss, ou bien est nulle, sur une grande partie de la surface.

2. Source d'arc selon la revendication 1, **caractérisée en ce que** la valeur de la composante perpendiculaire du champ magnétique B_{┴} est inférieure à 20 Gauss, de préférence inférieure à 10 Gauss.

3. Source d'arc selon l'une des revendications précédentes, **caractérisée en ce que** la plus grande partie de la surface s'étend d'une région centrale de la surface de la cible jusqu'à dans une région de bordure, c'est-à-dire de telle sorte que la plus grande partie occupe au moins 50%, notamment de préférence 60% ou plus, de la dimension ou des dimensions géométriquement déterminantes de la surface de la cible.

4. Source d'arc selon l'une des revendications précédentes, **caractérisée en ce que**, dans la région de bordure de la surface de la cible, les valeurs B_{┴R} de la composante perpendiculaire du champ magnétique augmentent, diminuent et/ou changent de signe par rapport aux valeurs B_{┴M} dans la région centrale de la surface de la cible.

5. Source d'arc selon l'une des revendications précédentes,
**caractérisée en ce que** la valeur de la composante parallèle Bₗₗ du champ magnétique est sensiblement nulle au milieu et augmente ou diminue en direction du bord de la surface de la cible, de préférence symétriquement par rapport au milieu de la cible, notamment de préférence augmente de façon sensiblement linéaire.

6. Source d'arc selon l'une des revendications précédentes, **caractérisée en ce que** le premier des deux systèmes magnétiques de polarités opposées au moins comporte au moins une première bobine électromagnétique montée derrière la cible.

7. Source d'arc selon la revendication 6, **caractérisée en ce que** les dimensions intérieures de la première bobine coïncident avec la projection des dimensions extérieures de la surface sensiblement avec un écart de plus ou moins 30% au maximum, de préférence plus ou moins 20%.

8. Source d'arc selon l'une des revendications 1 à 5, **caractérisée en ce que** le premier des deux systèmes magnétiques de polarités opposées au moins est constitué d'un ou plusieurs aimants permanents montés derrière la cible.

9. Source d'arc selon la revendication 8, **caractérisée en ce que** le ou les aimants permanents possèdent eux-mêmes une faible intensité de champ ou se trouvent à une distance de la cible telle que l'intensité du champ à la surface de la cible est faible.

10. Source d'arc selon l'une des revendications précédentes, **caractérisée en ce que** le deuxième des deux systèmes magnétiques de polarités opposées au moins comporte au moins une deuxième bobine placée coaxialement au premier système magnétique.

11. Source d'arc selon la revendication 10, **caractérisée en ce que** la deuxième bobine est placée derrière le premier système magnétique.

12. Source d'arc selon la revendication 10, **caractérisée en ce que** la deuxième bobine se trouve à une certaine distance en avant de la cible.

13. Source d'arc selon la revendication 10, **caractérisée en ce que** la deuxième bobine porte le premier système magnétique disposé au moins partiellement coaxialement.

14. Source d'arc selon l'une des revendications 10 à 13, **caractérisée en ce que** la deuxième bobine a un nombre d'enroulements et/ou un diamètre qui est supérieur à celui de la première bobine.

15. Source d'arc selon l'une des revendications précédentes, **caractérisée en ce que** la cible est montée en cathode.

16. Source d'arc selon l'une des revendications précédentes, **caractérisée en ce que** la cible est montée en anode.

17. Installation à vide, dans laquelle est disposée au moins une source d'arc selon l'une des revendications 1 à 16.

18. Installation selon la revendication 17, **caractérisée en ce que** la source d'arc au moins agit en direction de l'axe de l'installation et comporte au moins une autre bobine électromagnétique placée concentriquement à l'axe de l'installation afin de dévier le faisceau de plasma généré.

19. Installation selon la revendication 18, **caractérisée en ce que** l'autre bobine au moins est raccordée à au moins une source de courant variable dans le temps dotée d'une unité de commande afin de dévier de façon variable l'orientation du faisceau de plasma généré par la source d'arc au moins.

20. Installation selon l'une des revendications 18 à 19, **caractérisée en ce que** au moins deux autres bobines électromagnétiques sont disposées concentriquement à l'axe de l'installation, de préférence dans la région supérieure ainsi que dans la région inférieure respectivement dans les régions correspondantes latéralement adjacentes de l'installation, qui ont un diamètre identique ou différent respectivement une structure correspondant sensiblement à un agencement de bobine de Helmholz.

21. Procédé d'exploitation d'une décharge en arc à la surface d'une cible d'une source d'arc à l'aide d'un dispositif générateur de champ magnétique, **caractérisé en ce qu'**un champ magnétique est généré à la surface avec le dispositif générateur de champ magnétique constitué d'au moins deux systèmes magnétiques de polarités opposées de telle sorte que, sur une grande partie de la surface, sa composante perpendiculaire B_{⊥} est nulle ou a une valeur faible sensiblement constante inférieure 30 Gauss.

22. Procédé selon la revendication 21, **caractérisée en ce que** la valeur de la composante perpendiculaire du champ magnétique est réglée de façon à être inférieure à 30 Gauss, de préférence inférieure à 20 Gauss, notamment de façon préférée inférieure à 10 Gauss.

23. Procédé selon l'une des revendications 21 à 22, **caractérisée en ce que** le champ magnétique est réglé de sorte que la plus grande partie de la surface s'étend d'une région médiane de la surface de la cible à une région de bordure avec une composante perpendiculaire B_{⊥} sensiblement constante proche de zéro, c'est-à-dire que la région centrale occupe au moins 50%, notamment de préférence 60% ou plus, de la dimension ou des dimensions géométriquement déterminantes de la surface de la cible.

24. Procédé selon l'une des revendications 21 à 23, **caractérisée en ce que** les valeurs B_{⊥R} de la composante perpendiculaire du champ magnétique sont réglées de façon à augmenter, diminuer et/ou changer de signe par rapport aux valeurs B_{┴M} dans la région centrale de la surface de la cible.

25. Procédé selon l'une des revendications 21 à 24, **caractérisé en ce que** la valeur de la composante parallèle Bₗₗ du champ magnétique est réglée de façon à être nulle au centre et à augmenter en direction du bord de la surface de la cible, de préférence à augmenter symétriquement par rapport au centre de la cible, de sorte que la force agissant dans le sens horaires ou dans le sens antihoraire, tangentiellement au rayonnement électromagnétique, augmente en direction du bord de la cible.

26. Procédé selon l'une des revendications 21 à 24, **caractérisé en ce qu'**un champ magnétique lointain, orienté sensiblement perpendiculairement à la surface, est généré en plus dans une région située devant la cible.

27. Procédé selon l'une des revendications 21 à 26, **caractérisé en ce que** l'intensité du champ magnétique est réglée de façon à correspondre au matériau de la cible et/ou à l'épaisseur de la cible.

28. Procédé selon l'une des revendications 21 à 27, **caractérisé en ce que** le dispositif générateur de champ magnétique comporte au moins une bobine placée derrière la cible et **en ce qu'**une source de tension est appliquée à la bobine au moins pour régler le champ magnétique de façon à ce qu'un courant circule dans un premier sens.

29. Procédé selon l'une des revendications 21 à 27, **caractérisé en ce que** le dispositif générateur de champ magnétique comporte au moins un système magnétique placé derrière la cible et constitué d'un ou plusieurs aimants permanents.

30. Procédé selon l'une des revendications 28 à 29, **caractérisé en ce qu'** une deuxième bobine au moins est placée derrière la cible, devant la cible, ou en entourant la cible et **en ce qu'**une tension est appliquée à la deuxième bobine afin de régler le champ magnétique de façon à générer un deuxième champ magnétique opposé au champ magnétique généré par le premier système magnétique.

31. Procédé de revêtement d'une pièce, notamment d'un outil et/ou d'un composant en utilisant l'un des procédés selon les revendications 20 à 29.

32. Procédé de revêtement d'une pièce, notamment d'un outil et/ou d'un composant en utilisant une source d'arc selon les revendications 1 à 16.
